Europäisches Patentamt

(19) European Patent Office

Office européen des brevets

(11) Publication number: **0 342 466**
A2

## (12) EUROPEAN PATENT APPLICATION

(21) Application number: **89108234.9**

(51) Int. Cl.⁴: **G11C 11/40**

(22) Date of filing: **08.05.89**

(30) Priority: **16.05.88 US 194455**

(43) Date of publication of application:
**23.11.89 Bulletin 89/47**

(84) Designated Contracting States:
**DE FR GB IT NL**

(71) Applicant: **NATIONAL SEMICONDUCTOR CORPORATION**
**2900 Semiconductor Drive P.O. Box 58090**
**Santa Clara California 95051-8090(US)**

(72) Inventor: **Smith, Frederick**
**17334 Palo Vista Road**
**Cupertino, Ca.95014(US)**
Inventor: **Yu, Robert**
**25751 Vinedo Lane**
**Los Altos, Ca. 94022(US)**

(74) Representative: **Sparing - Röhl - Henseler**
**Patentanwälte**
**Rethelstrasse 123 Postfach 14 02 68**
**D-4000 Düsseldorf(DE)**

(54) Static ram with single event immunity.

(57) A new and improved semiconductor memory device incorporating a coupling capacitor between two CMOS inverters to immunize the circuit from radiation interference without the known disadvantages of resistive hardened memory device.

FIG. 3

This invention relates in general to an improved random access memory and in particular to a static random access memory with an improved technique for immunizing the memory to single event upsets due to an ionizing radiation hit.

While static RAMs are less sensitive to single event upsets, such as ion penetration, than are dynamic RAMs, the data in conventional static RAM circuits without any immunity or radiation hardness can be destroyed in the event of ion penetration. This is because certain radiation impulses can cause the RAM memory latch to make unplanned state changes from which the circuit is unable to recover once the radiation is no longer present.

The most well known prior art technique or method for immunizing a static RAM against such single event ion penetrations is by incorporating decoupling resistors between the two storage nodes. With this method the storage nodes are isolated until the RAM latch has had an opportunity to recover its logic state prior to the ion radiation hit. However, with this decoupling resistor technique there are usually extra process steps and masks required.

The entire response time of the circuit is also increased since the write cycle must be extended. Resistance slows the transition time so that the latch cannot be written accidentally by an ionizing pulse. Thus, this method is time dependent. With this technique a finite delay, say 5 ns, must be added to the feedback loop of the latch to prevent single event upsets. To deliberately write resistively hardened latches by normal means, thus requires an electrical pulse width of a longer duration, say at least 10 ns, thereby extending or increasing the normal response time of the circuit.

Also, where resistors are put into the memory cell to harden the circuit to radiation impulses, the resistors have been found to create additional problems due to the large variation in their value. It is difficult to control the actual value of a resistor because of its sensitivity to temperature and because of variations in the processing of the resistors, i.e., doping levels, line widths, etc.

However, while resistive hardened circuits may impose certain restraints on the memory circuit, such as an upper limit of approximately 50-100 MHz on the frequency of the latch operation, this technique of employing the resistors does not appreciably increase the circuit real estate or area. Such a feature is desirable in fabricating memory devices. Therefore, prior to the present invention, the decoupling resistor technique was the best technique known for immunizing a RAM to single event upsets.

On the other hand, it is desirable to have a memory device which is immune to single event upsets but which does not have the drawbacks associated with the memory devices incorporating decoupling resistors. That is, it is desirable to have a memory device which gives all of the benefits of decoupling resistors but which does not make use of the resistors. Consequently, it is desirable to have a static random access memory device which is immune to the single event upsets such as ionizing radiation pulses but where the efficiency and response time of the circuit are not compromised. It is also desirable to have an improved memory device which is immune to radiation interference but which does not appreciably increase the area or size of the circuit.

It is therefore an object of the invention to:

(1) provide a static random access memory device which is immune to single event upsets and which eliminates the undesirable results of resistive hardening and other prior art hardening techniques, and

(2) provide single event immunity to a static random access memory without appreciably increasing the size of the memory device or compromising the normal response time of the circuit.

The broadest aspect of the present invention is defined in claim 1.

In view of the commonly known problems which still exist with respect to static random access memories which are not sufficiently immune to single event upsets and which must incorporate decoupling resistors in order to immunize the circuit to radiation interference and the other known disadvantages of resistive hardened memory devices, it is clear that there is a need in the semiconductor industry for a static random access memory with radiation hardness which accomplishes the objects defined above. According to the invention semiconductor memory device which incorporates a coupling capacitor between the two storage nodes to achieve radiation hardness of the circuit. The invention eliminates the undesirable side effects of resistive hardening such as the increased response time of the circuit. The invention also make permits to use of a capacitor which is more stable over process variations and temperature variations than are resistors. Furthermore, the capacitor does not require any additional die area.

In addition, other advantages and characteristic features of the invention will become more apparent to those skilled in the art upon further consideration of the following description of the drawings wherein like reference numerals refer to like parts or elements of the invention and the detailed description of the best mode for carrying out the invention.

Figure 1 is a typical 6-transistor static RAM cell with a cross-coupled inverter pair having no additional components to provide single event upset immunity.

Figure 1A plots the voltage change on storage nodes 1 and 2 when there is a logic change on the nodes caused by a current impulse I due to an ionizing radiation hit.

Figure 2 is similarly a typical 6-transistor static RAM cell with a cross-coupled inverter pair but which has immunity to single event upset, which immunity is provided by resistors in the cross-coupled inverter pair.

Figure 2A plots the voltage change on storage nodes 1 and 2 when there is a current impulse I caused by an ionizing radiation hit. Since the voltages on nodes $Q'$ and $\overline{Q}'$ never intersect, the memory cell eventually recovers to its original logic state, and there is no loss of data.

Figure 3 illustrates the invention with a typical 6-transistor static RAM cell, but incorporating the single event upset immunity without the use of the cross-coupled resistors.

Figure 3A plots the voltage change over nodes 1 and 2 against time when there is a current impulse I caused by an ionizing radiation hit. Since the voltage waveforms for the Q and $\overline{Q}$ nodes do not cross, the memory cell eventually recovers to its original logic state and there is no loss of data.

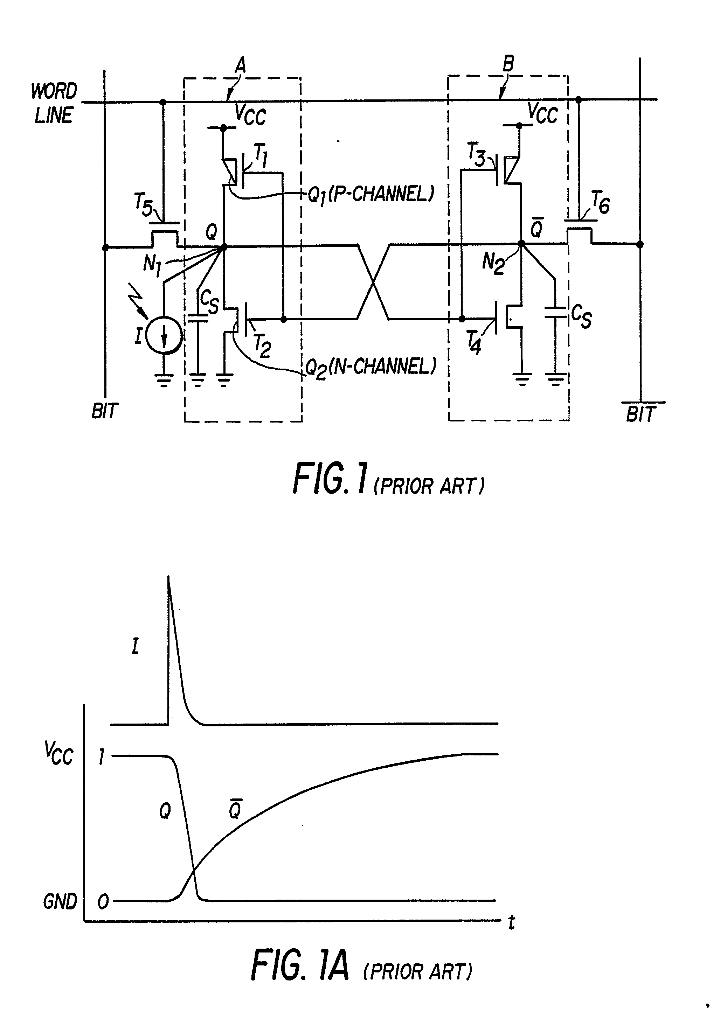

Figure 1 typifies the problem occurring in static RAMs where no immunity is provided against single event upset. Figure 1 has two standard CMOS inverters A and B. Each inverter is balanced with a storage node and the same number of N and P channel transistors T1-T6. Nodes $N_1$ and $N_2$ are storage nodes for data and its complement, $\overline{data}$. Each of nodes $N_1$ and $N_2$ has a parasitic or stray capacitance, $C_s$. The current source, I, represents the impulse caused by a radiation hit to the Q side of the memory latch, i.e. to node $N_1$.

Figure 1A illustrates what happens to the voltages at nodes $N_1$ and $N_2$ when the RAM cell is penetrated by an ionizing radiation hit. This hit generates a current impulse, I, which causes the Q side of the memory latch to discharge from a logic "1" level to ground, allowing the $\overline{Q}$ side of the latch to go high. Thus, the original data stored in the memory cell is destroyed by the radiation hit. Clearly, the RAM has no protection against the outside interference and false data can be written in the memory to compromise its usefulness.

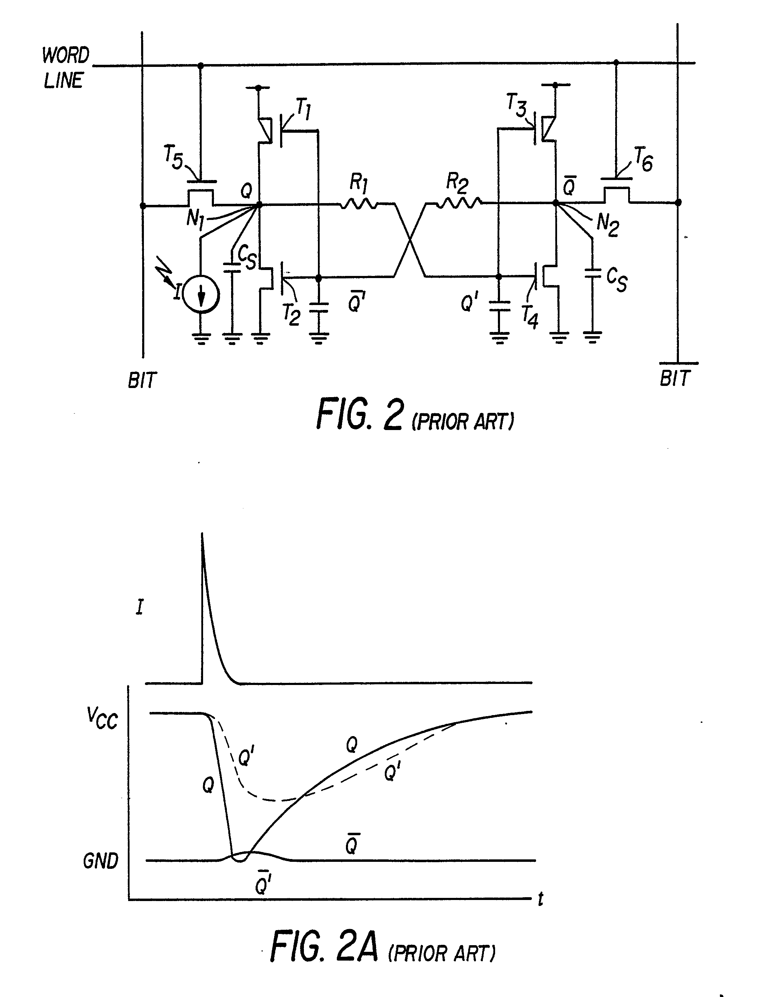

Figure 2 illustrates the well known prior art technique for protecting the Figure 1 RAM against interference from outside radiation sources. Similarly, Figure 2 has two standard CMOS inverters which are balanced on each side with storage nodes $N_1$ and $N_2$ and the same number of N-channel and P-channel transistors. In addition, the Figure 2 circuit has been supplied with decoupling resistors $R_1$ and $R_2$. Resistors $R_1$ and $R_2$ must be of a value sufficient to delay the transition period for the $Q'$ and $\overline{Q}'$ nodes after the Q and $\overline{Q}$ nodes respectively. That is, if the transition of the $Q'$ and $\overline{Q}'$ nodes is sufficiently delayed such that the voltages on these nodes do not cross during the radiation hit, they will recover to their original values and the cell will be immunized from the single event upset and no false state of the storage nodes will be written on the cross-latched latch.

Figure 2A plots the voltage drop over nodes $N_1$ and $N_2$ where there is a decoupling resistor between the two nodes to delay their write cycle. As illustrated, the voltage waveforms for $Q'$ and $\overline{Q}'$ do not cross and therefore the memory cell recovers to its original logic state after the radiation pulse is finished. Even though this technique of resistive hardening against radiation interference is viable, there are enough disadvantages and undesirable side effects of this resistive hardening technique such that a more desirable technique is warranted.

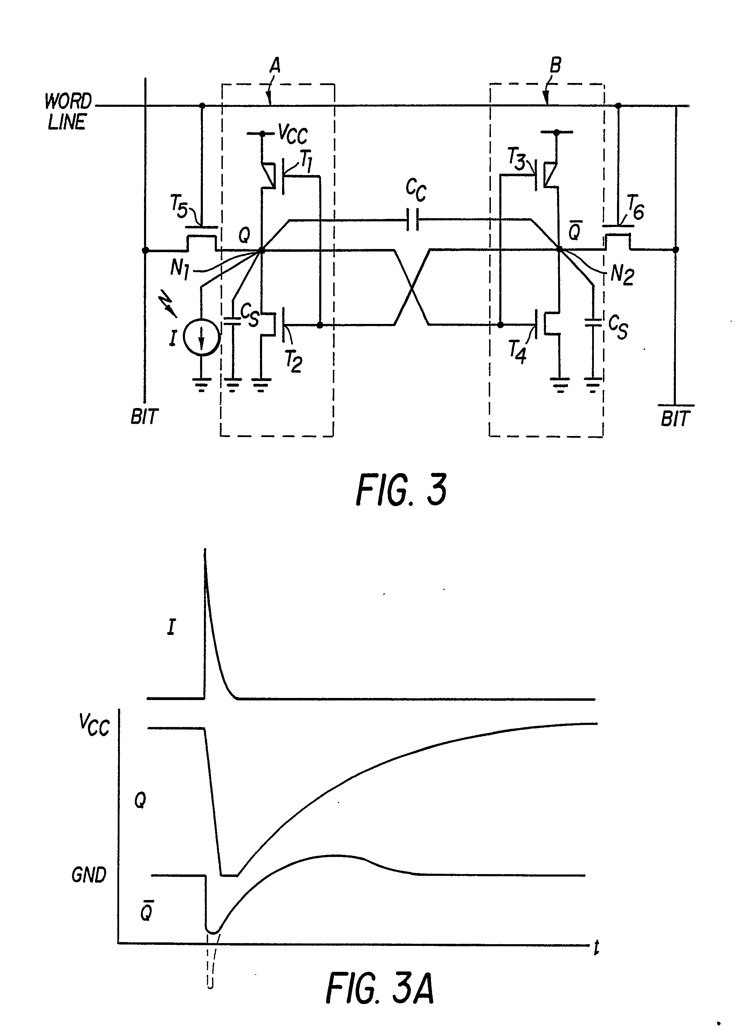

The invention as set forth in Figure 3 provides for a more desirable alternative to the resistive hardening technique against radiation interference. As in both of the prior art memory devices discussed above, the memory device is only vulnerable when a single event ion or outside radiation interference hits the storage node when the node is in the logic "1" state. That is, if a single event ion or radiation interference should hit a data storage node $N_1$ in the logic "0" state, there will be no detrimental effect on the circuit.

Where a single event ion hits a data storage node in a logic "1" state, the output voltage of the data side of the inverter A in this example will rapidly drop towards 0 Volts. Ordinarily, as the data side (Q) of the latch drops towards ground the $\overline{data}$ side ( $\overline{Q}$ ) of the latch will be driven high towards Vcc. This sequence occurs in both the circuits illustrated in Figure 1 and Figure 2. However, in the case of Figure 2 resistors $R_1$ and $R_2$ have been added to delay the transition period or the time in which it takes both inverters A and B to reverse their voltage.

However, in the case of the Figure 3 circuit, resistors $R_1$ and $R_2$ have been replaced with a coupling capacitor $C_c$ across the $Q'$ and $\overline{Q}'$ nodes. As is known, the voltage across Cc cannot change instantaneously, thus adding the potential for greater stability to the circuit in the event of a single event upset.

Assuming a single event ion hit on storage node $N_1$, the transition of $N_1$ from an original logic state of "1" at Vcc to a new logic state of "0" at 0V occurs. Simultaneously, due to the capacitor coupling effect, the voltage on storage node $N_2$ will

also change and will be driven down from OV to a negative voltage value approaching -Vcc. Now the voltage across both nodes $N_1$ and $N_2$ is dropping in the same direction with the voltage across $N_1$ fast approaching 0 while the voltage across $N_2$ fast approaching -Vcc. This voltage drop across nodes $N_1$ and $N_2$ is illustrated in Fig. 3A. As is further illustrated in Fig. 3A, the voltages across $N_1$ and $N_2$ will never be equal as occurs for the prior art circuits illustrated at the crossover points in Figs. 1A and 2A. This lack of a crossover point of the voltages across $N_1$ and $N_2$ makes the circuit of Fig. 3 immune to single event upsets.

In practice, the voltage drop at $N_2$ is limited by the P-N diode clamping between the transistor drain and the substrate or well. This clamps the voltage at $N_2$ to approximately one diode voltage drop below ground. At this point, both sides of the CMOS latch have a logic "0" input even though the two stages (inverters A and B) are being driven by different voltages. This is an unstable condition for the latch and both stages of the latch will initially attempt to drive high. However, because the output of node $N_2$ is approximately one diode drop lower than the output of $N_1$ the inherent voltage gain of the cross-coupled latch will drive these nodes to their correct levels assuming the latch has been properly designed and balanced, i.e. $N_1$ will achieve its original logic state of "1" before $N_2$ is able to go high. As $N_1$ achieves a logic state of "1", it will drive $N_2$ back to its logic state of "0" and the inverters will both resume their logic states prior to the radiation interference.

The minimum size of the coupling capacitor Cc may be determined by the inequality

$$\frac{C_C}{C_C + C_S} \times V_{CC} \geq 1v$$

$$i.e. \quad C_C \geq \frac{C_S}{V_{CC} - 1}$$

A typical coupling capacitor may be equal to half Cs.

While the invention has been described with specific applications primarily directed to radiation hardening for static RAMs, it is anticipated that the invention may also be applied to the hardening of latches in general, e.g., storage registers, shift registers, counters, etc. Furthermore, the invention may have applications outside of the area of radiation hardening. For example, the invention may be used to improve the immunity of a memory cell to power supply glitches for poly-load-resistor RAMs. This increased stability will become critically important as memory cells shrink in size with each generation of technology advancement.

Also, while the invention has been described with specific application to static RAM designed for CMOS process technology it is anticipated to have application for other process technologies, e.g., NMOS, Bipolar, etc.

## Claims

1. In a semiconductor memory device of the type having a plurality of transistor means ($T_1$ - $T_6$), each of said transistor means having a source, drain and a gate and wherein each of said transistors is electrically connected to the adjacent transistor and the drains of at least two adjacent transistors are coupled with a capacitive means.($C_c$).

2. In a semiconductor memory device of the type having a plurality of transistor means ($T_1$ - $T_6$), each of said transistor means having a source, drain and a gate, with the gates of the first and second transistor means being connected to the drains of the third and fourth transistor means, and with the gates of the third and fourth transistor means being coupled to the drains of the first and second transistor means, wherein the improvement comprises capacitive means for coupling the drain of one of said transistor means ($C_c$)to the drain of another one of said transistor means.

3. In a semiconductor memory device of the type having a plurality of transistor means, each of said transistor means having a source, drain and gate, with the drain of the first ($T_1$) of said transistor means being connected to the drain of the second ($T_2$) transistor means and the drain of the third ($T_3$) transistor means being connected to the drain of the fourth transistor means and with the drain of the third transistor means being connected to the gates of the first and second transistor means and the drain of the first transistor means being connected to the gates of the third and fourth transistor means, wherein the improvement comprises capacitive means ($C_c$) for coupling the drains of the first ($T_1$) and second ($T_2$) transistor means to the drains of the third ($T_3$) and fourth ($T_4$) transistor means.

**FIG.1** (PRIOR ART)

**FIG. 1A** (PRIOR ART)

FIG. 2 (PRIOR ART)

FIG. 2A (PRIOR ART)

FIG. 3

FIG. 3A